# EUROPEAN PATENT SPECIFICATION

(11) **EP 4 367 991 B1**
(45) Date of publication and mention of the grant of the patent: **25.11.2026**
(21) Application number: 22747944.1
(22) Date of filing: 04.07.2022
(51) Int. Cl.: H10N 60/80, H10N 60/01, H01R 4/68

(54) **JOINT OF MGB2 SUPERCONDUCTING WIRES AND CORRESPONDING JOINING METHOD**
VERBINDUNG VON MGB2-SUPRALEITERDRÄHTEN UND ENTSPRECHENDES VERBINDUNGSVERFAHREN
JONCTION DE FILS SUPRACONDUCTEURS MGB2 ET PROCÉDÉ DE RACCORDEMENT CORRESPONDANT

(30) Priority: 06.07.2021 EP 21250004
(43) Date of publication of application: 15.05.2024
(73) Proprietor: NV Bekaert SA, 8550 Zwevegem (BE); Epoch Wires Limited, Cambridge, Cambridgeshire CB22 6SA (GB)
(72) Inventor: ATAMERT, Serdar, Cambridge, Cambridgeshire CB22 6SA (GB); KUTUKCU, Mehmet, Cambridge, Cambridgeshire CB22 6SA (GB); D'HULST, Chris, 8720 Oeselgem (BE); MESTDAGH, Jan, 8780 Oostrozebeke (BE)
(86) International application number: PCT/EP2022/068364
(87) International publication number: WO 2023/280735

(56) References cited:
- EP-A2- 1 276 171
- GB-A- 2 448 051
- KR-A- 20200 103 369
- KR-B1- 101 343 887
- KR-B1- 101 343 887
- US-A1- 2012 061 139
- LI X H ET AL: "High critical current joint of MgB2 tapes using Mg and B powder mixture as flux", SUPERCONDUCTOR SCIENCE AND TECHNOLOGY, vol. 21, 025017, 23 January 2008 (2008-01-23), XP020128600, DOI: 10.1088/0953-2048/21/2/025017

## Description

### Technical Field

The invention relates to a joint of superconducting wires with magnesium diboride (MgB₂) as superconducting core and to a method of making such a joint.

### Background Art

Magnesium diboride is an inorganic compound with the formula MgB₂. Magnesium diboride's superconducting properties were discovered in 2001. MgB₂ becomes superconducting at 39 K (-234 °C), which is the highest amongst conventional superconductors. This allows the functioning as superconductor without the need for using liquid helium.

In order to keep its superconducting properties, the very low electrical resistance must also be present at joints, where two ends of superconducting wire are joined. Having regard to the very fragile properties of the superconducting material, this is not a straightforward task.

The prior art has disclosed various alternatives for realizing a superconducting joint.

US-A1-2009/0105079 discloses a superconductive connection for two end pieces of superconductors using a sheath or bushing where MgB₂ as superconductive contacting material is inserted. The superconductors are multi-wire superconductors. The connection shows a region inside the sheath or bushing where the superconducting wires overlap, i.e. the cross-section shows the presence of superconducting wires coming from the two end pieces of superconductors.

US-2012/061139A1 discloses a similar superconductive connection wherein the MgB₂ conductor leads are directly sheated with a barrier layer and embedded in a normally conductive matrix material, whereby the material of the barrier layer and the matrix material are different. The conductor leads of the end pieces are at least partially stripped of the matrix material and the barrier material is not present at least in an endface connecting region of the conductor leads.

GB-22448051A discloses a method of joining superconductive wires. The method comprises the steps of:
- preparing an end of a first wire in a mateable configuration, wherein the first wire comprises superconductive magnesium diboride filaments surrounded by a conductive cladding;
- preparing an end of a second wire in a mateable configuration, wherein the second wire comprises superconductive magnesium diboride filaments surrounded by a conductive cladding;
- mateably joining the end of the first wire to the end of the second wire;
- surrounding the mateably joined end of the first wire and the end of the second wire in a wrapping material.EP-1276171A2 discloses a superconductive connection for two end pieces of superconductors where MgB₂ as superconducting powder is inserted. A metallic powder or alloy powder having a melting point lower than said superconducting powder can be added to said mixture of superconducting powder and metal powder.

KR-101343887B1 discloses a welding method for superconductive wires.

KR-A-10-2020-0103369 discloses a superconductive connection for two end pieces of superconductors of the single wire type. The superconductor of the single wire type is a round wire with a MgB₂ superconducting core surrounded by a stabilization layer and a metal sheath. In order to realize the connection, the end pieces of the superconducting wires are flattened to a very large degree to increase the bonding area. The width to thickness ratio ranges from 3 to 100. The stabilization layer and metal sheath are removed at one side of the flattened ends so that the superconducting cores become open at one side. The open sides of the superconducting cores are then brought in contact with each other. The contacting ends are introduced in a bonding container where sintered powder of Mg and B or of MgB₂ is introduced and put under pressure.

Another joining technique of MgB2 tapes using a Mg and B powder mixture as flux is disclosed in LI X H ET AL: "High critical current joint of MgB2 tapes using Mg and B powder mixture as flux", SUPERCONDUCTOR SCIENCE AND TECHNOLOGY, vol. 21, 025017, 23 January 2008. The joining processes comprises the steps of:
- peeling off the sheath materials of the tapes to be joined from one end using mechanical polishing;
- adding a finely ground Mg and B powder mixture between the contacting surfaces of the cores;
- compressing the joint to a pressure of up to ~0.6 GPa perpendicular to the contacting surfaces of the cores for further strengthening and improving the density of the joined part;
- putting the joint into a furnace with an Ar protective atmosphere at ambient pressure for heat treatment at a sintering temperature of 973 K for 1 h.

### Disclosure of Invention

It is an object of the invention to provide for an alternative superconductive joint.

It is another object of the invention to simplify superconductive joints.

It is a specific object of the invention to allow jointing of superconductive wires with already reacted MgB₂.

According to the first aspect of the invention there is provided a joint of superconducting wires according to independent claim 1. The joint comprises at least two superconducting wires each with a sheath and with a MgB₂ superconducting core inside the sheath. At least one first superconducting wire has a first flattened end and at least one second superconducting wire has a second flattened end. The joint further comprises a tubular metal connector. The connector has a centre being filled with magnesium and boron or with MgB₂ material. The first flattened end of first superconducting wire is inserted at one side of the connector until it is in contact with the magnesium and boron or the MgB₂ material. The second flattened end of the second superconducting wire is inserted at the other side of the connector until it is also in contact with the magnesium and boron or the MgB₂ material. The connector is pressed at both sides to fix the first superconducting wire and the second superconducting wire. The centre of the connector is pressed to compact the magnesium and boron or the MgB₂ material.

In comparison with the prior art, this invention joint does not need the superconducting wires to have an overlap. In addition, there is no need to remove the sheath of the superconducting wires.

The first flattened end and the second flattened end have a width-to-thickness ratio in order to get rid of the cavities and to provide a stable pressed wire that is no longer deformed during pressing of the connector. The flattened ends have a width to thickness ratio ranging from 1.1 to 5.0, e.g. from 1.25 to 2.5 preferably from 1.50 to 2.0.

Since the first superconducting wire and the second superconducting wire comprise a core of reacted superconducting MgB₂ they also comprise voids. The reason is that the volume of reacted MgB₂ is roughly 25% less than the original Mg powders and B powders. The ends of the superconducting wires are pressed to such a degree that the number and volume of voids decrease. Later pressing of these already pressed ends of superconducting wires will no longer lead to large cracks which prevent electrical current.

The tubular metal connector preferably comprises low carbon steel.

The tubular metal connector may also comprise titanium.

The tubular metal connector may have a titanium barrier radially inside and a low carbon steel radially outside.

The tubular metal connector may preferably be made of low carbon steel only.

According to a second aspect of the invention there is provided a method of joining at least two superconducting wires having a superconducting core of reacted MgB₂ according to independent claim 5. This method comprises the following steps:
a) providing at least one first superconducting wire and at least one second superconducting wire, the first superconducting wire having a first end and the second superconducting wire having a second end;
b) flattening the first end of the first superconducting wire and flattening the second end of the second superconducting wire;
c) providing a tubular metal connector having a length Lₜₒₜ and having a centre;
d) filling the centre of said connector with unreacted Mg powder and B powder;
e) flattening the connector in case the connector has an original circular cross-section;
f) inserting the first end of the first superconductor at one side in the connector over a length L₁ until contact with the Mg powder and B powder;
g) inserting the second end of the second superconductor at the other side in the connector over a length L₂ until contact with the Mg powder and B powder;
h) pressing the connector at both sides to fix the first superconductor wire and the second superconductor wire in the connector;
i) pressing the centre of the connector over a length L_{center} to compact the Mg powder and B powder, wherein the lengths Lₜₒₜ, L₁, L₂ and L_{center} match the following equation:${L}_{tot} = {L}_{1} + {L}_{2} + 2 ⋅ {L}_{cr} + {L}_{center}$ where L_{cr} is a critical distance between, on the one hand, the first flattened end and the second flattened end, and, on the other hand, the pressed length L_{center} of the centre of the connector needed to avoid that the superconducting wires are pressed together with the pressing of the centre.

In order to create superconductivity in the centre of the tubular metal connector and to restore the superconductivity in the flattened ends, the tubular metal connector and the flattened ends are subjected to a heat treatment.

This heat treatment preferably comprises two phases:
1) a first phase of heating in a range of 800 °C to 1000 °C during 20 minutes to 40 minutes; immediately followed by
2) a second phase of heating in a range of 550 °C to 750 °C during 45 minutes to 75 minutes.

Preferably the flattening of the ends of the superconducting wires are done to a degree where the width to thickness ratios of these ends range from 1.10 to 10.0, preferably from 1.10 to 5.0, most preferably from 1.50 to 2.5, e.g. from 1.50 to 2.0.

Preferable values of the critical distance L_{cr} range from 0.6 mm to 5.0 mm, preferably from 0.8 mm to 2.0 mm, e.g. from 0.8 mm to 1.2 mm.

### Brief Description of Figures in the Drawings

FIGURE 1 is a schematic presentation of a preparation of a joint according to the invention.
FIGURE 2 shows a joint according to the invention.

### Mode(s) for Carrying Out the Invention

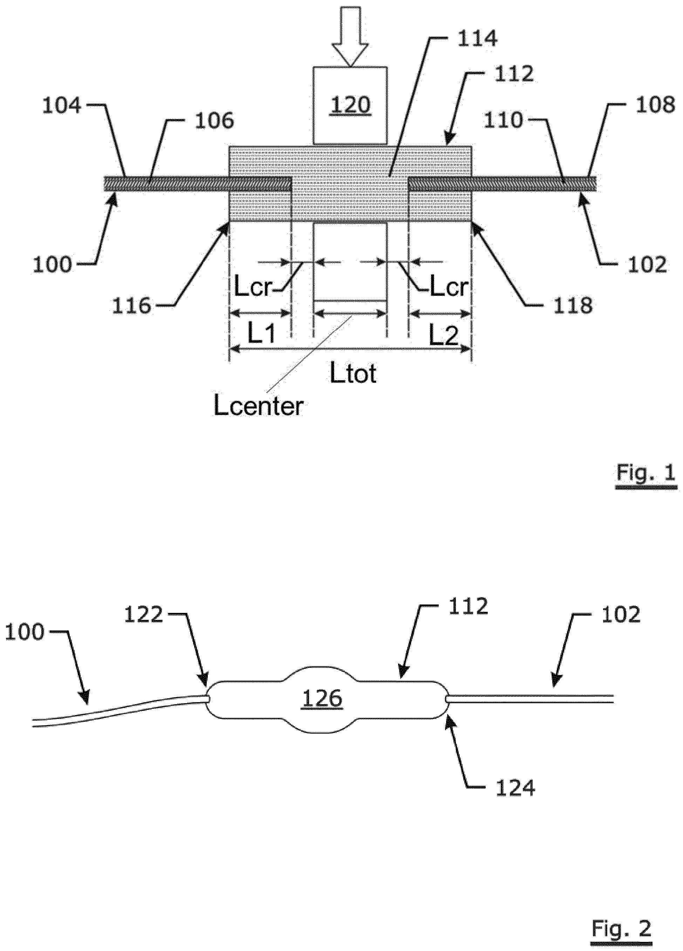

Referring to FIGURE 1 the subsequent steps or joining a first superconducting wire 100 and a second superconducting wire 102 will be described. The numerical values are given by way of non-limiting example.

The first superconducting wire 100 has a sheath 104 of low carbon steel and a core 106 of reacted MgB₂.
The second superconducting wire 102 has a sheath 108 with a barrier layer of titanium and an outer layer of low carbon steel and a core 110 of reacted MgB₂.

A tubular metal connector 112 is provided and contains unreacted boron powder and magnesium powder. The boron powder is preferably a nano boron powder and the magnesium powder is preferably a spherical magnesium powder. By way of example, the external diameter of the tubular metal connector 112 is 5.6 mm to 6.0 mm and the metal tubular connector 112 is about 22 mm long.

The first end 116 and the second end 118 of the metal tubular connector 112 are first deburred.

Then, the first end 116 of the tubular metal connector 112 and the second end 118 of the tubular metal connector are immersed in a diluted HCl solution for a couple of seconds and thereafter dried under vacuum.

Both the first and 116 and the second end 118 are polished followed by alcohol washing and vacuum drying.

A hole of 1.25 mm is drilled in both the first end 116 and the second end 118 to match the dimensions of the first and the second superconducting wires 100 and 102. The length of the hole is L₁ at the sided of the first end 116 and L₂ at the side of the second end 118. Both L₁ and L₂ can be about 6.5 mm.

After drilling, the tubular metal connector 112 is flattened over its whole length Lₜₒₜ.

The first superconducting wire 100 and the second superconducting wire are flattened over a length that is greater than the drilling lengths L₁ and L₂.

The thus flattened ends of the first and second superconducting wire 100 and 102 are ground with an angle in order to increase the surface area. This grinding operation is again followed by alcohol washing and vacuum drying. Thereafter, the flattened ends of the first and second superconducting wires 100 and 102 dipped in a diluted solution of HCl, followed by washing in alcohol and drying in vacuum.

The flattened ends of the first and second superconducting wires 100 and 102 are inserted in the tubular metal connector 112 until they have contact with the boron and magnesium powder in the centre.

Pressure is exercised at both ends 116 and 118 of the tubular metal connector 112 in order to fix the superconducting wires 100 and 102 and to seal the ends 116 and 118.

The centre part of the tubular metal connector 112 is pressed over a length L_{center} by means of a hydraulic press 120. The length L_{center} before flattening is for example 6.35 mm.
A critical length L_{cr} of 1.0 mm remains at both sides between the flattened centre part of the tubular metal connector 112 and the drilled holes.

Finally, a heat treatment is applied to the assembly of the first and second superconducting wires 100, 102 and the tubular metal connector 112 with the Mg and B powder 114.

As mentioned, the heat treatment comprises two phases.

During the first phase the assembly is heated at 900 °C during 30 minutes. In this first phase, the following reaction takes place:
2MgB₂ → Mg + MgB₄

During the second phase immediately following the first phase, the assembly is kept at a temperature of 650 °C during 60 minutes. During this second phase, the following reaction takes place:
Mg + MgB₄ → 2MgB₂

This double phase heat treatment not only create superconductivity in the centre of the tubular metal connector 112 but also restores the superconductivity in the flattened ends of the first and second superconducting wires 100 and 102.

FIGURE 2 gives a schematical representation of a realized joint. More particularly, FIGURE 2 shows the pressed ends 122 and 124 of the tubular metal connector 112 and the flattened central part 126. Typical dimensions in the finalized joint, i.e. after the flattening operations, are a total length Lₜₒₜ of 23.8 mm, a length L_{center} of the flattened central part of 7.25 mm, a length of insertion of first superconducting wire of 7.9 mm and a length of insertion of second superconducting wire of 8.7 mm.

### List of Reference Numbers

- 100: first superconducting wire
- 102: second superconducting wire
- 104: sheath of first superconducting wire
- 106: reacted MgB₂ inside first superconducting wire
- 108: sheath of second superconducting wire
- 110: reacted MgB₂ inside second superconducting wire
- 112: tubular metal connector
- 114: unreacted Mg powder and B powder
- 116: first end of tubular metal connector
- 118: second end of tubular metal connector
- 120: pressing tool
- 122: first pressed end of tubular metal connector
- 124: second pressed end of tubular metal connector
- 126: central pressed part of tubular metal connector

### List of abbreviations in Figures

- L₁: length of insertion of first superconducting wire
- L₂: length of insertion of second superconducting wire
- Lₜₒₜ: length of the tubular metal connector
- L_{cr}: critical length
- L_{center}: length of pressure zone in central part of tubular metal connector

## Claims

1. A joint of superconducting wires,
said joint comprising at least two superconducting wires (100, 102) each with a sheath (104, 108) and with a core of reacted superconducting MgB₂ (106, 110),
at least one first superconducting wire (100) having a first flattened end and at least one second superconducting wire (102) having a second flattened end,
wherein said first flattened end and said second flattened end have a width to thickness ratio ranging from 1.1 to 5.0,
said joint further comprising a tubular metal connector (112) having a length Lₜₒₜ,
said connector having a centre being filled with magnesium and boron or with MgB₂ material (114),
said first flattened end of said at least one first superconducting wire being inserted at one side of said connector until it is in contact with said magnesium and boron or said MgB₂ material over a length L₁, said second flattened end of said at least one second superconducting wire being inserted at the other side of said connector until it is in contact with said magnesium and boron or said MgB₂ material over a length L₂,
said connector being pressed at both sides to fix said at least one first superconducting wire and said at least one second superconducting wire, said centre of said connector being pressed over a length L_{center} to compact said magnesium and boron or said MgB₂ material, wherein said lengths Lₜₒₜ, L₁, L₂ and L_{center} match the following equation: ${L}_{tot} = {L}_{1} + {L}_{2} + 2 ⋅ {L}_{cr} + {L}_{center}$
where L_{cr} is a critical distance between, on the one hand, the first flattened end respectively the second flattened end and, on the other hand, the pressed length L_{center} of the centre of the connector needed to avoid that the superconducting wires are pressed together.

2. The joint according to claim 1
wherein said tubular metal connector comprises low carbon steel.

3. The joint according to claim 1 or claim 2,
wherein said tubular metal connector comprises titanium.

4. The joint according to claim 2 or claim 3,
wherein said tubular metal connector has a titanium barrier inside and a low carbon steel around said titanium barrier.

5. A method of joining at least two superconducting wires having a superconducting core of reacted MgB₂, said method comprising the following steps:
a. providing at least one first superconducting wire (100) and at least one second superconducting wire (102), said at least one first superconducting wire having a first end and said at least one second superconducting wire having a second end;
b. flattening said first end of said first superconducting wire and flattening said second end of said second superconducting wire;
c. providing a tubular metal connector (112) having a length Lₜₒₜ and having a centre;
d. filling said centre of said connector with unreacted Mg powder and B powder (114);
e. flattening said connector in case said connector has an original circular cross-section;
f. inserting said first end of said least one first superconductor (100) at one side (116) in said connector over a length L₁ until contact with said Mg powder and B powder;
g. inserting said second end of said at least one second superconductor (102) at the other side (118) in said connector over a length L₂ until contact with said Mg powder and B powder;
h. pressing said connector at both sides to fix said at least one first superconductor wire and said at least one second superconductor wire in said connector;
i. pressing said centre of said connector over a length L_{center} to compact said Mg and B powder, wherein said lengths Lₜₒₜ, L₁, L₂ and L_{center} match the following equation: ${L}_{tot} = {L}_{1} + {L}_{2} + 2 ⋅ {L}_{cr} + {L}_{center}$ where L_{cr} is a critical distance between, on the one hand, the first flattened end respectively the second flattened end and, on the other hand, the pressed length L_{center} of the centre of said connector needed to avoid that the superconducting wires are pressed together with the pressing of said centre.

6. The method according to claim 5,
wherein said method comprises the following step:
subjecting said connector and said first flattened end and second flattened end to a heat treatment to create superconductivity in the centre and to restore superconductivity in said first flattened end and second flattened end.

7. The method according to claim 6,
wherein said heat treatment comprises a first phase of heating in a range of 800 °C to 1000 °C during 20 minutes to 40 minutes and a second phase of heating in a range of 550 °C to 750 °C during 45 minutes to 75 minutes.

8. The method according to any one of claims 5 to 7,
wherein flattening said first end of said at least one first superconducting wire and flattening said second end of said at least one second superconducting wire are done to a degree where the width to thickness ratio of said first end and of said second end range from 1.25 to 2.5, preferably from 1.50 to 2.0.

9. The method according to any one of claims 5 to 8,
wherein said critical distance L_{cr} ranges from 0.6 mm to 5.0 mm.

## Patentansprüche

1. Verbindung von supraleitenden Drähten,
die Verbindung umfassend mindestens zwei supraleitende Drähte (100, 102) mit jeweils einem Mantel (104, 108) und einem Kern aus umgesetztem supraleitendem MgB₂ (106, 110),
wobei mindestens ein erster supraleitender Draht (100) ein erstes abgeflachtes Ende aufweist und mindestens ein zweiter supraleitender Draht (102) ein zweites abgeflachtes Ende aufweist,
wobei das erste abgeflachte Ende und das zweite abgeflachte Ende ein Verhältnis von Breite zu Dick im Bereich von 1,1 bis 5,0 aufweisen,
die Verbindung ferner umfassend einen rohrförmigen Metallverbinder (112) mit einer Länge Lₜₒₜ.
wobei der Verbinder eine Mitte aufweist, die mit Magnesium und Bor oder mit MgB₂-Material (114) gefüllt ist,
wobei das erste abgeflachte Ende des mindestens einen ersten supraleitenden Drahts an einer Seite des Verbinders eingeführt wird, bis es mit dem Magnesium und dem Bor oder dem MgB₂-Material über eine Länge L₁ in Kontakt steht,
wobei das zweite abgeflachte Ende des mindestens einen zweiten supraleitenden Drahts an der anderen Seite des Verbinders eingeführt wird, bis es mit dem Magnesium- und Bor- oder dem MgB₂-Material über eine Länge L₂ in Kontakt steht,
wobei der Verbinder auf beiden Seiten zusammengepresst wird, um den mindestens einen ersten supraleitenden Draht und den mindestens einen zweiten supraleitenden Draht zu fixieren,
wobei die Mitte des Verbinders über eine Länge L_{center} zusammengepresst wird, um das Magnesium und das Bor oder das MgB₂-Material zu verdichten,
wobei die Längen Lₜₒₜ, L₁, L₂ und L_{center} der folgenden Gleichung entsprechen: ${L}_{tot} = {L}_{1} + {L}_{2} + 2 ⋅ {L}_{cr} + {L}_{center}$
wobei L_{cr} ein kritischer Abstand zwischen dem ersten abgeflachten Ende bzw. dem zweiten abgeflachten Ende einerseits und der zusammengepressten Länge L_{center} der Mitte des Steckverbinders andererseits ist, der erforderlich ist, um zu verhindern, dass die supraleitenden Drähte zusammengepresst werden.

2. Verbindung nach Anspruch 1
wobei der röhrenförmige Metallverbinder kohlenstoffarmen Stahl umfasst.

3. Verbindung nach Anspruch 1 oder 2,
wobei der röhrenförmige Metallverbinder Titan umfasst.

4. Verbindung nach Anspruch 2 oder 3,
wobei der röhrenförmige Metallverbinder eine Titanbarriere im Inneren und einen kohlenstoffarmen Stahl um die Titanbarriere herum aufweist.

5. Verfahren zum Verbinden von mindestens zwei supraleitenden Drähten mit einem supraleitenden Kern aus umgesetztem MgB₂, das Verfahren umfassend die folgenden Schritte:
a. Bereitstellen mindestens eines ersten supraleitenden Drahts (100) und mindestens eines zweiten supraleitenden Drahts (102),
wobei der mindestens eine erste supraleitende Draht ein erstes Ende aufweist und der mindestens eine zweite supraleitende Draht ein zweites Ende aufweist;
b. Abflachen des ersten Endes des ersten supraleitenden Drahts und Abflachen des zweiten Endes des zweiten supraleitenden Drahts;
c. Bereitstellen eines rohrförmigen Metallverbinders (112) mit einer Länge Lₜₒₜ und mit einer Mitte;
d. Füllen der Mitte des Verbinders mit nicht umgesetztem Mg-Pulver und B-Pulver (114);
e. Abflachen des Verbinders, falls der Verbinder ursprünglich einen kreisförmigen Querschnitt aufweist;
f. Einsetzen des ersten Endes des mindestens einen ersten Supraleiters (100) an einer Seite (116) in den Verbinder über eine Länge L₁ bis zum Kontakt mit dem Mg-Pulver und dem B-Pulver;
g. Einführen des zweiten Endes des mindestens einen zweiten Supraleiters (102) an der anderen Seite (118) in den Verbinder über eine Länge L₂ bis zum Kontakt mit dem Mg-Pulver und dem B-Pulver;
h. Zusammenpressen des Verbinders auf beiden Seiten, um den mindestens einen ersten Supraleiterdraht und den mindestens einen zweiten Supraleiterdraht in dem Verbinder zu fixieren;
i. Zusammenpressen der Mitte des Verbinders über eine Länge L_{center}, um das Mg- und das B-Pulver zu kompaktieren,
wobei die Längen Lₜₒₜ, L₁, L₂ und L_{center} der folgenden Gleichung entsprechen: ${L}_{tot} = {L}_{1} + {L}_{2} + 2 ⋅ {L}_{cr} + {L}_{center}$
wobei L_{cr} ein kritischer Abstand zwischen dem ersten abgeflachten Ende bzw. dem zweiten abgeflachten Ende einerseits und der zusammengepressten Länge L_{center} der Mitte des Steckverbinders andererseits ist, der erforderlich ist, um zu verhindern, dass die supraleitenden Drähte beim Zusammenpressen der Mitte zusammengepresst werden.

6. Verfahren nach Anspruch 5,
wobei das Verfahren den folgenden Schritt umfasst:
Aussetzen des Verbinders und des ersten abgeflachten Endes und des zweiten abgeflachten Endes einer Wärmebehandlung, um Supraleitung in der Mitte zu erzeugen und Supraleitung in dem ersten abgeflachten Ende und dem zweiten abgeflachten Ende wiederherzustellen

7. Verfahren nach Anspruch 6,
wobei die Wärmebehandlung eine erste Phase des Erhitzens in einem Bereich von 800 °C bis 1000 °C über 20 Minuten bis 40 Minuten und eine zweite Phase des Erhitzens in einem Bereich von 550 °C bis 750 °C über 45 Minuten bis 75 Minuten umfasst.

8. Verfahren nach einem der Ansprüche 5 bis 7,
wobei das Abflachen des ersten Endes des mindestens einen ersten supraleitenden Drahts und das Abflachen des zweiten Endes des mindestens einen zweiten supraleitenden Drahts in einem Umfang durchgeführt werden, sodass das Verhältnis von Breite zu Dicke des ersten Endes und des zweiten Endes im Bereich von 1,25 bis 2,5, vorzugsweise von 1,50 bis 2,0 liegt.

9. Verfahren nach einem der Ansprüche 5 bis 8,
wobei der kritische Abstand L_{cr} im Bereich von 0,6 mm bis 5,0 mm liegt.

## Revendications

1. Jonction de fils supraconducteurs,
ladite jonction comprenant au moins deux fils supraconducteurs (100, 102), chacun comportant une gaine (104, 108) et un noyau en MgB₂ (106, 110) supraconducteur ayant subi des réactions,
au moins un premier fil supraconducteur (100) présentant une première extrémité aplatie et au moins un second fil supraconducteur (102) présentant une seconde extrémité aplatie,
ladite première extrémité aplatie et ladite seconde extrémité aplatie présentant un rapport largeur sur épaisseur dans la plage comprise entre 1,1 et 5,0,
ladite jonction comprenant en outre un connecteur tubulaire métallique (112) comportant une longueur Lₜₒₜ,
ledit connecteur comportant un centre rempli de magnésium et de bore ou de matériau MgB₂ (114),
ladite première extrémité aplatie dudit au moins un premier fil supraconducteur étant insérée au niveau d'un côté dudit connecteur jusqu'à être en contact avec ledit magnésium et bore ou ledit matériau MgB₂ sur une longueur L₁,
ladite seconde extrémité aplatie dudit au moins un second fil supraconducteur étant insérée au niveau de l'autre côté dudit connecteur jusqu'à être en contact avec ledit magnésium et bore ou ledit matériau MgB₂ sur une longueur L₂,
ledit connecteur étant pressé au niveau des deux côtés pour fixer ledit au moins un premier fil supraconducteur et ledit au moins un second fil supraconducteur,
ledit centre dudit connecteur étant pressé sur une longueur L_{center} pour compacter ledit magnésium et bore ou ledit matériau MgB₂,
lesdites longueurs Lₜₒₜ, L₁, L₂ et L_{center} étant conformes à l'équation suivante : ${L}_{tot} = {L}_{1} + {L}_{2} + 2 ⋅ {L}_{cr} + {L}_{center}$
où L_{cr} est une distance critique entre, d'une part, la première extrémité aplatie respectivement la seconde extrémité aplatie et, d'autre part, la longueur pressée L_{center} du centre du connecteur nécessaire pour éviter que les fils supraconducteurs ne soient pressés ensemble.

2. Jonction selon la revendication 1,
ledit connecteur métallique tubulaire comprenant de l'acier doux.

3. Jonction selon la revendication 1 ou la revendication 2,
ledit connecteur tubulaire métallique comprenant du titane.

4. Jonction selon la revendication 2 ou la revendication 3,
ledit connecteur métallique tubulaire comportant une barrière en titane à l'intérieur et de l'acier doux autour de ladite barrière en titane.

5. Procédé de raccordement d'au moins deux fils supraconducteurs comportant un noyau supraconducteur de MgB₂ ayant subi des réactions, ledit procédé comprenant les étapes consistant à :
a. fournir au moins un premier fil supraconducteur (100) et au moins un second fil supraconducteur (102),
ledit au moins un premier fil supraconducteur présentant une première extrémité et ledit au moins un second fil supraconducteur présentant une seconde extrémité ;
b. aplatir ladite première extrémité dudit premier fil supraconducteur et aplatir ladite seconde extrémité dudit second fil supraconducteur ;
c. fournir un connecteur métallique tubulaire (112) comportant une longueur Lₜₒₜ et comportant un centre ;
d. remplir ledit centre dudit connecteur de poudre de Mg n'ayant pas ayant subi de réaction et de poudre de B (114) ;
e. aplatir ledit connecteur dans le cas où ledit connecteur présente une section circulaire d'origine ;
f. insérer ladite première extrémité dudit au moins un premier supraconducteur (100) au niveau d'un côté (116) dans ledit connecteur sur une longueur L₁ jusqu'au contact avec lesdites poudre de Mg et poudre de B ;
g. insérer ladite seconde extrémité dudit au moins un second supraconducteur (102) au niveau de l'autre côté (118) dans ledit connecteur sur une longueur L₂ jusqu'au contact avec lesdites poudre de Mg et poudre de B ;
h. presser ledit connecteur au niveau des deux côtés pour fixer ledit au moins un premier fil supraconducteur et ledit au moins un second fil supraconducteur dans ledit connecteur ;
i. presser ledit centre dudit connecteur sur une longueur L_{center} pour compacter ladite poudre Mg et B, lesdites longueurs Lₜₒₜ, L₁, L₂, L_{center} étant conformes à l'équation suivante : ${L}_{tot} = {L}_{1} + {L}_{2} + 2 ⋅ {L}_{cr} + {L}_{center}$ où L_{cr} est une distance critique entre, d'une part, la première extrémité aplatie respectivement la seconde extrémité aplatie et, d'autre part, la longueur pressée L_{center} du centre dudit connecteur nécessaire pour éviter que les fils supraconducteurs ne soient pressés ensemble avec le pressage dudit centre.

6. Procédé selon la revendication 5,
ledit procédé comprenant l'étape consistant à :
soumettre ledit connecteur et ladite première extrémité aplatie et ladite seconde extrémité aplatie à un traitement thermique pour créer une supraconductivité au centre et pour restaurer la supraconductivité dans ladite première extrémité aplatie et ladite seconde extrémité aplatie.

7. Procédé selon la revendication 6,
ledit traitement thermique comprenant une première phase de chauffage dans une plage de 800 °C à 1 000 °C pendant 20 minutes à 40 minutes et une seconde phase de chauffage dans une plage de 550 °C à 750 °C pendant 45 minutes à 75 minutes.

8. Procédé selon l'une quelconque des revendications 5 à 7,
l'aplatissement de ladite première extrémité dudit au moins un premier fil supraconducteur et l'aplatissement de ladite seconde extrémité dudit au moins un second fil supraconducteur étant effectués à un degré où le rapport largeur sur épaisseur de ladite première extrémité et de ladite seconde extrémité est compris entre 1,25 et 2,5, de préférence entre 1,50 et 2,0.

9. Procédé selon l'une quelconque des revendications 5 à 8,
ladite distance critique L_{cr} étant comprise entre 0,6 mm et 5,0 mm.
